Europäisches Patentamt

European Patent Office

Office européen des brevets

(11) Publication number: **0 424 808 A1**

# EUROPEAN PATENT APPLICATION

(21) Application number: 90120013.9

(51) Int. Cl.⁵: **G01R 33/38, G01R 33/28**

(22) Date of filing: 18.10.90

(30) Priority: 21.10.89 JP 275561/89
25.09.90 JP 251717/90
25.09.90 JP 251718/90

(43) Date of publication of application:
**02.05.91 Bulletin 91/18**

(84) Designated Contracting States:
**DE NL**

(71) Applicant: **Kabushiki Kaisha Toshiba
72, Horikawa-cho Saiwai-ku
Kawasaki-shi(JP)**

(72) Inventor: **Yokoi, Motohisa, c/o Intellectual
Property Div.
K. K. Toshiba, 1-1 Shibaura 1-chome
Minato-ku, Tokyo 105(JP)**
Inventor: **Tsuruno, Daihachiro, c/o Intellectual
Property Div
K. K. Toshiba, 1-1 Shibaura 1-chome
Minato-ku, Tokyo 105(JP)**

(74) Representative: **Blumbach Weser Bergen
Kramer Zwirner Hoffmann Patentanwälte
Radeckestrasse 43
W-8000 München 60(DE)**

(54) Magnetic resonance imaging apparatus.

(57) A magnetic resonance imaging apparatus in which a subject (108) under examination is placed on a top board (106) of an examination couch and the top board (106) is moved horizontally to dispose the subject (108) in a static magnetic field generated by a superconducting magnet system. The superconducting magnet system comprises a pair of main magnets (12, 14) opposed to each other horizontally to generate the static magnetic field in the direction in which the magnets are opposed, an access aperture (16b) which allows the top board (106) to pass through in the direction normal to the static magnetic field, an opening formed above the access aperture (16b) and a coupling device (16) coupling the main magnets (12, 14) to each other and comprised of three to six magnetic materials.

FIG. 2

# MAGNETIC RESONANCE IMAGING APPARATUS

The present invention relates to an electromagnet type nuclear magnetic resonance (NMR) imaging apparatus for acquiring morphological information, such as cross-sectional NMR images, and functional information, such as NMR spectroscopy, of a subject under examination (an organism) by utilization of nuclear magnetic resonance phenomena.

Means for generating a static magnetic field for use with such a magnetic resonance imaging apparatus include a Helmholtz coil, a solenoid, an electromagnet using a superconducting coil and a permanent magnet. The permanent magnet can generate a magnetic field as high as some thousands of gausses, thus failing to obtain a high homogenous static magnetic field over a large region. Therefore, the permanent magnet is not suitable for use with apparatus adapted for special imaging or large-region imaging. In apparatus for special imaging or large-region imaging use is made mostly of a electromagnet as static magnetic field generating means. Note that systems using an electromagnet include a transverse magnetic field system in which a static magnetic field is generated horizontally and a longitudinal magnetic field system in which a static magnetic field is generated vertically.

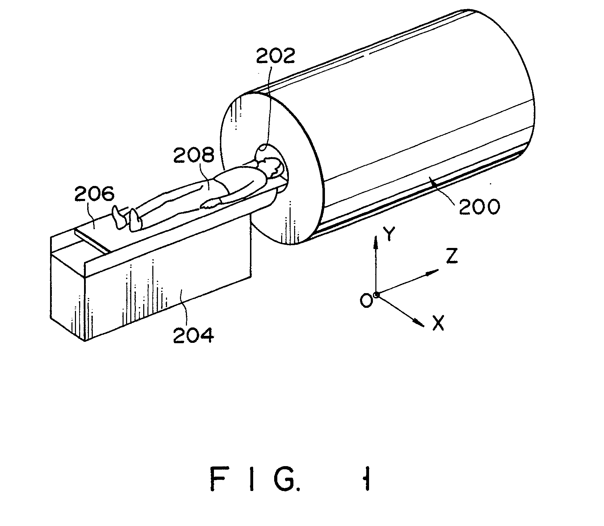

Fig. 1 is a perspective view of a conventional electromagnet type magnetic resonance imaging apparatus using a transverse magnetic field type of superconducting magnet as static magnetic field generating means. A transverse magnetic field type superconducting magnet 200 forms a closed double cylindrical body whose both ends along its axis are closed. For example, the Z axis of the XYZ coordinate system is selected to be coincident with the axis of the cylindrical body. At least a superconducting coil and a cooling medium, such as liquid helium, for placing the coil in a superconducting state are housed within the closed double cylindrical body. The coil is adapted to generate a static magnetic field along the Z-axis direction.

Gradient field forming coils and a probe coil, which are not shown, are also incorporated in a cavity 202 of the superconducting magnet 200. The cavity 202 forms a space into which a subject under examination is accessed. An examination couch 204 is disposed to face the opening of the cavity 202 of the superconducting magnet 200, and a sliding top board 206 is provided on the couch 204. The subject 208 is placed on the sliding top board 206. Slicing of the top board allows the subject 208 access to the cavity 202 of the superconducting magnet 200.

When the subject 208 is placed in the cavity 202, a static magnetic field is generated and gradient magnetic fields formed by the gradient field coils and a radio-frequency (RF) excitation magnetic field formed by the probe coil are superimposed upon the static magnetic field. Thereby, magnetic resonance is induced in a specific body portion of the subject 208 so that nuclear magnetic resonance (NMR) signals are produced. The NMR signals are acquired by the probe head and then applied to a computer system (not shown) for image reconstruction.

With the conventional electromagnet type magnetic resonance imaging apparatus described above, the subject 208 is obliged to be restrained placed within the narrow, deep and dim cavity 202 for a long time interval of several minutes to several tens of minutes. Thus, mental pain that the subject 208 suffers will be great as compared with the case of X-ray CT scanners which are often compared with magnetic resonance imaging apparatus as imaging diagnostic apparatus.

Furthermore, with the conventional electromagnet type magnetic resonance imaging apparatus described above, the imaging prccess is performed with the subject 208 placed within the cavity 202. Thus, the subject 208 hs to be subjected to imaging with his or her whole body stretched out in a lying position (lying face downward or upward). A problem with the conventional apparatus is therefore that the subject cannot be imaged in a standing position for his or her waist portion and the like with a stress added to his or her spinal column, that is, in such a condition as the subject is in activity. Although the transverse magnetic field type was described, the same applies to the longitudinal magnetic field type.

With the apparatus with the above construction, a problem will arise in that a solenoid having a higher sensitivity than a saddle-shaped coil cannot be used because the direction of the static magnetic field is coincident with the body axis of the subject and thus an improvement in image quality cannot be achieved. There is another problem in that the cavity, the inside of which is dark, will make the subject, or a patient uneasy. A further problem is that there is leakage of the static magnetic field because the cavity opens in the direction of the static magnetic field.

It is therefore an object of the present invention to provide a magnetic resonance imaging apparatus which achieves an improvement in image quality, avoids making a subject under examination uneasy and effects a reduction in leakage magnetic field.

It is the other object of the present invention to provide an electromagnet type magnetic resonance imaging apparatus which inflicts little pain on a subject under examination and enables imaging of the subject not only in a lying position but also in a standing position.

The above objects are attained by the following apparatuses.

In a magnetic resonance image apparatus in which a subject under examination is placed on a top board of an examination couch and the top board is moved horizontally to dispose the subject in a static magnetic field generated by a superconducting magnet system, the superconducting magnet system comprises a pair of main magnets disposed to each other horizontally and generating the static magnetic field in the direction in which the main magnets are opposed, an access aperture which allows the top board to pass through in the direction normal to the static magnetic field, an opening formed above the access aperture and a coupling device coupling the main magnets to each other.

The above objects are also attained by the following apparatus.

In electromagnetic type magnetic resonance imaging apparatus which induces magnetic resonance within a specific body portion of a subject under examination by placing the subject in a static magnetic field generated by an electromagnet type static magnetic field generating means and applying gradient magnetic fields and a radio-frequency excitation magnetic field and acquires magnetic resonance signals resulting from the magnetic resonance to obtain diagnostic information, the improvement wherein the electromagnet type static magnetic field generating means comprises a static magnetic field generating coil, a yoke, a first magnetic pole magnetically coupled with an end of the yoke and a second magnetic pole magnetically coupled with the other end of the yoke and opposed to the first magnetic pole.

Furthermore, the above objects are also attained by the following apparatus.

In an electromagnet type magnetic resonance imaging apparatus which induces magnetic resonance within a specific body portion of a subject under examination by placing the subject in a static magnetic field generated by an electromagnet type static magnetic field generating means and applying gradient magnetic fields and a radio-frequency excitation magnetic field and acquires magnetic resonance signals resulting from the magnetic resonance to obtain diagnostic information, the improvement wherein the electromagnet type static magnetic field generating means comprises an iron core having a magnetic gap in which the subject is placed and forming a substantially U-shaped magnetic circuit and a coil disposed to pass magnetic flux through the magnetic circuit of the yoke.

This invention can be more fully understood from the following detailed description when taken in conjunction with the accompanying drawings, in which:

FIG. 1 is a schematic illustration of the external appearance in perspective of the superconducting magnet system and the examination couch system of a conventional magnetic resonance imaging apparatus;

FIG. 2 is a schematic illustration of a magnetic resonance imaging apparatus according to a first embodiment of the present invention;

Fig. 3 is a sectional view taken along the line III-III of Fig. 2;

Fig. 4 is a diagram for use in explanation of magnetic lines of force;

Figs. 5A, 5B and 5C illustrate relationships of a static magnetic field with magnetic fields produced by probe coils;

Fig. 6 is a sectional view of magnetic resonance imaging apparatus according to a second embodiment of the present invention;

Fig. 7 is a sectional view of an electromagnet type magnetic resonance imaging apparatus according to a third embodiment of the present invention;

Fig. 8 and 9 are perspective views of examples of the layout of the apparatus of Fig. 7;

Fig. 10 is a sectional view of a second embodiment of the electromagnet type magnetic resonance imaging apparatus according to the present invention;

Figs. 11 and 12 are perspective views, partly in section, of arrangements of superconducting magnets for use in the apparatus of Fig. 10;

Fig. 13 is a perspective view of an example of the layout of the apparatus of Fig. 10;

Fig. 14 is a sectional view of the third embodiment of the present invention.

Fig. 15 is a sectional view of the third embodiment of the present invention.

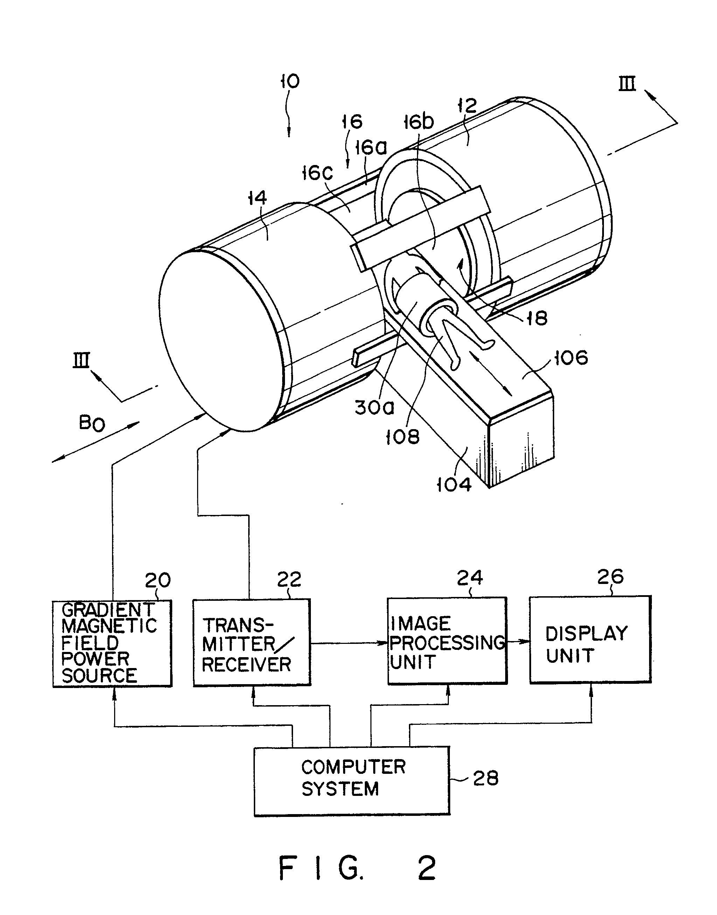

Fig. 2 schematically illustrates a magnetic resonance imaging apparatus according to a first embodiment of the present invention.

The apparatus illustrated generally at 10 comprises a static magnetic field generating means and other components. The static magnetic field generating means comprises superconducting magnet systems 12 and 14 adapted to generate a static magnetic field in the superconducting state and a coupling device 16 having a plurality of coupling plates (four in this embodiment) 16a for coupling the superconducting magnet systems 12 and 14 to each other, each coupling plate consisting principally of a magnetic material such as ferrite.

The other components include an examination couch system 204 provided with a top board 206 on which a subject under examination 208 is to be placed, gradient magnetic field coils 18 for generating gradient magnetic fields, a transmitter coil not shown for transmitting an RF excitation pulse in the direction orthogonal to the static magnetic field Bo, a power source 20 for supplying power to the gradient magnetic field coils 18, a solenoid type of coil 30a for receiving MR signals from the subject 208, a transmitter and receiver 22 for transmitting the excitation pulse to the transmitter coil and receiving the MR signals from the solenoid type of coil 30a, an image processing unit 24 for performing image reconstruction processing on the basis of the MR signals received from the solenoid type coil 30a, an image display unit 26 for displaying an image reconstructed by the image processing unit 24 and a computer system 28 for controlling various units of the apparatus 10.

The coupling plates 16a are spaced to form an access aperture 16b for the subject and an opening 16c located above the aperture. The access aperture 16b is formed in such a way that the top board 206 may move perpendicular to the static magnetic field Bo. The illumination of a room in which the superconducting magnet systems 12 and 14 are installed can pass through the opening 16c.

In mounting the superconducting magnet systems 12 and 14, the systems can be coupled to each other by the coupling plates 16a after they are taken disassembled into a room for installation.

The superconducting magnet systems 12 and 14 are opposed to each other in the horizontal direction and have a pair of main magnets 12a and 14a forming the static magnetic field Bo on the direction in which the main magnets are opposed. The direction of the static magnetic field Bo formed by the main magnets 12a and 14a is coincident with the direction perpendicular to the body axis of the subject 208, namely, the direction perpendicular to the direction in which the top board is moved. The solenoid type coil 30a can detect signals of atomic nuclei that precess or rotate about the axis perpendicular to its central axis. Thus, the solenoid type coil 30a is disposed so that its central axis may be coincident with the direction of the body axis of the subject, thereby permitting the coil 30a to be adapted for use in the apparatus 10.

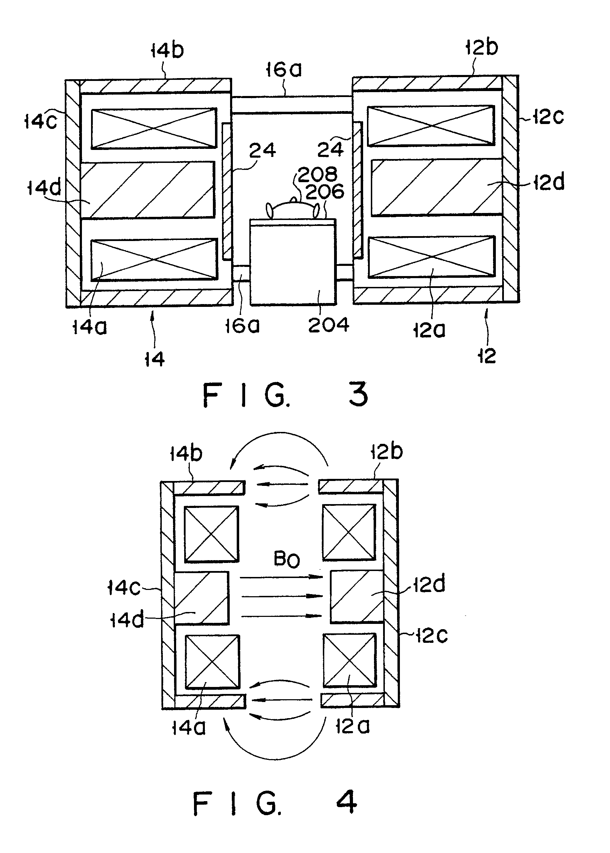

Fig. 3 is a sectional view taken along the line III-III of Fig. 2, which illustrates the internal structure of the superconducting systems 12 and 14.

As described above, the superconducting magnet systems 12 and 14 have main magnets 12a and 14a and gradient magnet field forming coils 18 disposed on the coupling device side of the main magnets 12a and 14a. The gradient magnetic field forming coils 18 from gradient magnetic fields which are superimposed upon the static magnetic field formed by the main magnets 12a and 14a.

Where the relative position of the main magnets is displaced due to the gradient magnetic fields, the static magnetic field on one side will become large. That is, inhomogeneity of the magnetic field will result due to induced magnetic field gradients. The inhomogeneity can be corrected by causing the gradient magnetic field coil 18 to form some amount of gradient magnetic fields at all times.

Each of the main magnets 12a and 14a is adapted to form a static magnetic field in the super conducting state and thus includes a superconducting coil formed of a superconducting material, liquid helium for cooling the coil and a vacuum vessel for cold reserving the liquid helium. Each main magnet is formed in cylindrical form as a whole. To confine magnetic lines of force of the static magnetic field formed by the main magnets 12a and 14a inside, magnetic materials 12b to 12d and 14b to 14d consisting principally of ferrite are disposed at various portions of the superconducting magnet systems 12 and 14. The magnetic materials 12b and 14b are disposed outside of the main magnets 12a and 14a, respectively. The magnetic materials 12c and 14c are disposed at the ends of the main magnets 12a and 14a, respectively. The magnetic materials 12d and 14d are disposed inside of the main magnets 12a and 14a, respectively.

The operation of the apparatus constructed as above will be described with reference to Fig. 4.

The main magnets 12a and 14a form a static magnetic field Bo in the direction perpendicular to the direction of movement of the top board. As shown in Fig. 4, the magnetic materials 12b to 12d and 14b to 14d disposed in the superconducting magnet systems 12 and 14 confine the static magnetic field produced by the main magnets. Thus, the leakage flux will be reduced.

Next, the subject 208 lying on the top board 206 is disposed within the static magnetic field. Subsequently, the solenoid type coil 30a is disposed around the subject 208 so that the direction of the central axis of the coil may be coincident with the direction of the body axis of the subject.

Under the control of the computer system 28, the gradient magnetic field coils 18 are powered from the power source 20 to apply gradient magnetic fields to the subject and the RF coil responds to an excitation pulse from the transmitter and receiver 22 to transmit RF excitation pulse in the direction normal to the static magnetic field.

The atomic nuclei within the subject precess or rotate about the axis normal to the central axis of the solenoid type coil 30a. Signals from those atomic nuclei, that is, MR signals are detected by the solenoid type coil 30a and then fed to the image processing unit 24 via the transmitter and receiver 22. The image processing unit 24 performs image reconstruction processing on the received MR signals. A reconstructed MR image is visually displayed by the image display unit 26.

By constructing the apparatus 10 as described above, the use of the solenoid type coil 30a is enabled, thus achieving an improvement in image quality. Moeover, the illumination of the room in which the superconducting magnet systems are installed is allowed to come into the inside through the opening, thus making the subject easy.

As shown in Fig. 4, the static magnetic field formed by the main magnets 12a and 14a can be confined inside, thereby reducing the leakage flux. By confining the magnetic field inside, the strength of the static magnetic field in the position in which the subject is disposed is made high, which will make the apparatus small and effect an improvement in image quality. Furthermore, the reduction in the leakage flux will make a magnetic-field management area small and an installation space for the superconducting magnet systems small. The superconducting magnet systems can be carried disassembled, making installation work easy.

In the embodiment of Fig. 2, the solenoid type coil 30a is used. Alternatively, a surface coil or a saddle-shaped coil may be used instead. Here, the Y-axis direction is the vertical direction, the X-axis direction is the horizontal direction along the right and left of the paper and the Z-axis direction is the horizontal direction along the top and bottom of the paper. Thus, the static magnetic field is generated in the X direction, the direction of the line of vision of the subject is oriented in the Y direction, and the direction of the body axis of the subject is the Z direction.

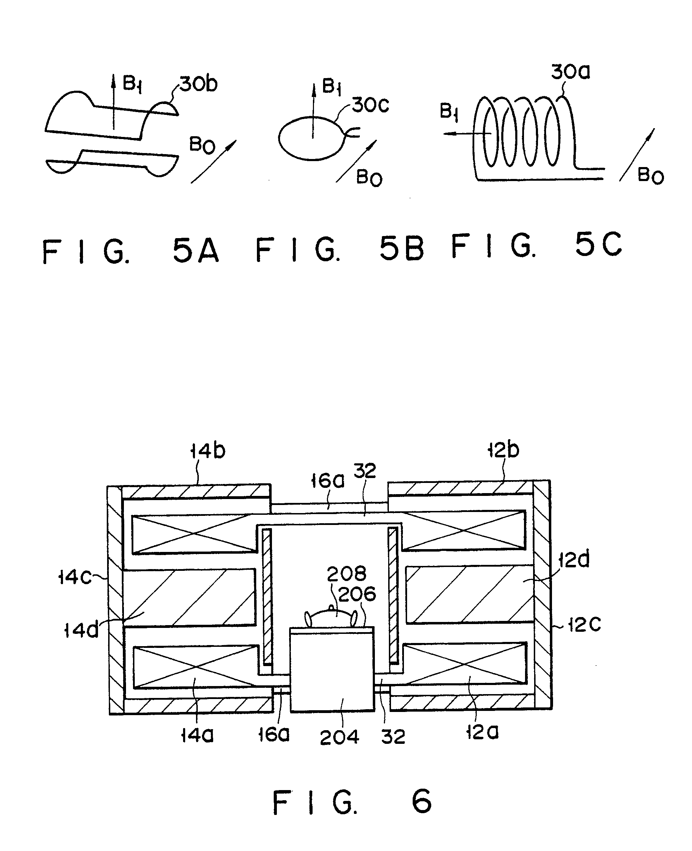

Arrangements of the probe coil will now be explained. From the principle of the magnetic resonance phenomenon it is essential that the static magnetic field Bo and the magnetic field B1 generated by the probe coil be orthogonal to each other. Thus, typical examples of the probe coil are: a saddle-shaped probe coil 30b as shown in Fig. 5A; a surface coil type probe coil 30c as shown in Fig. 5B; and a solenoid type probe coil 30a as shown in Fig. 5C.

Next, a modification of the apparatus shown in Fig. 2 will be described with reference to Fig. 6.

As shown, the main magnets 12a and 14 a are coupled by means of one or more coupling tubes 32. In the coupling tube 32 is disposed a conductor, preferably a superconductor, for electrically connecting the superconducting coil of the main magnet 12a and the superconducting coil of the main magnet 14a in series or in parallel. Also, the coupling tube 32 has a function of interchanging the superconducting coil cooling medium between the main magnets 12a and 14a.

By such a construction the main magnets 12a and 14a are electrically adapted for use as an integral type of magnet, which is advantageous for adjusting the magnetic characteristics such as magnetic field generation. Since the main magnet 12a and main magnet 14a can reciprocate their cooling medium, the supply of a cooling medium to one of the main magnets enables the supply of it to the other main magnet. Namely, the supply of cooling medium to the main magnets can conveniently be made at a time. The cooling mediums of the main magnets 12a and 14a will reduce at the same rate so that their magnetic characteristics change equally. This will facilitate to have a grasp of the magnetic characteristics.

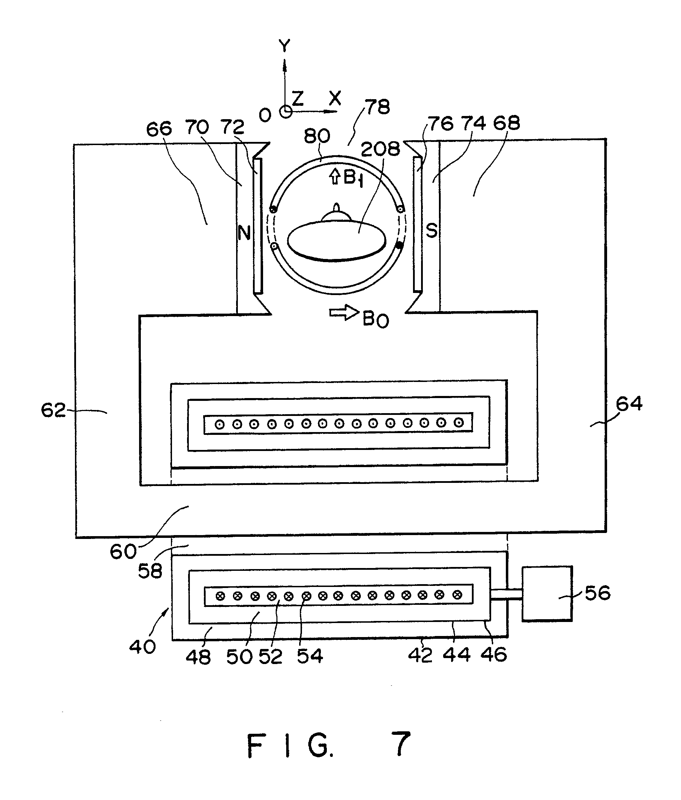

A second embodiment of the magnetic resonance imaging apparatus of the invention will be described with reference to Figs. 7, 8 and 9.

Fig. 7 is a sectional view of the apparatus according to the second embodiment. In Fig. 7, an electromagnet type static magnetic field generating device 40 may be a superconducting magnet which is used in the magnetic resonance imaging apparatus MRT-50A(0.5) or MRT-200 (1.5 or more) manufactured by TOSHIBA Co., Ltd.

The electromagnet type static magnetic field generating device (hereinafter referred to as the super-conducting magnet) 40 is of a triple-vessel structture consisting of a vacuum vessel 42 of a closed double-cylindrical structure whose both ends along its axis are closed, a shield vessel 44 disposed within the vacuum vessel 42 and a helium vessel 46 disposed within the shield vessel 44. A heat insulating material 48 is housed between the vacuum vessel 42 and the shield vessel 44, and a different type of heat insulating material 50 is also housed between the shield vessel 44 and the helium vessel 46. A superconducting coil 52 of a type in which a superconductor is wound in solenoid form and liquid helium 54 are housed in the helium vessel 46. The heat shielding vessel 44 is cooled by a built-on refrigerating machine 56.

A static magnetic field generation space 58 of the superconducting magnet 40 is formed in the direction in which a static magnetic field is generated. With the magnetic resonance imaging apparatus MRT-50A described above, gradient magnetic field coils and a whole-body probe coil are disposed in the space. In the present embodiment, a yoke iron core 60 formed of a high magnetic material is inserted into the space 58.

To both ends of the yoke iron core 60 are magnetically coupled substantially at right angles first and second iron cores 62 and 64 each consisting of a high magnetic material. The first iron core 62 has a first magnetic pole 66 formed at its other end that is not coupled with the yoke iron core 60. Also, the second iron core 64 has a second magnetic pole 68 formed at its other end that is not coupled with the yoke iron core 60. A first pole piece 70 for adjusting magnetic lines of force and a gradient field coil 72 are disposed at the end of the first magnetic pole 66. A second pole piece 74 for adjusting magnetic lines of force and a gradient field coil 76 are disposed at the end of the second magnetic pole 68. The pole faces (which are substantially the surfaces of the pole pieces 70 and 74 but the surfaces of the gradient field coils 72 and 76 in the drawing) of the first magnetic pole 66 (e.g., the N pole) and the second magnetic pole 68 (e.g., the S pole) are opposed to each other, thereby forming a space 78 in which a static magnetic field is generated.

As can be seen, the yoke iron core 60, the first iron core 62 and the second iron core 64 form a substantially U-shaped iron core and a ring magnetic circuit is formed by the iron core and the space 78. Within the space 78 the subject 208 is disposed with the face upward on the top board of the couch not shown and, for example, a saddle-shaped probe coil 80 is disposed.

According to the present embodiment, the space 78 formed between the first and second magnetic poles 66 and 68 is adapted for use as the static field generation space, and the subject can be disposed within the space 78 for MR imaging. In this case, the first and second magnetic poles 66 and 68 are only opposed to each other and do not close the space 78 from all sides. In other words, the field of view of the subject is restricted by the first and second magnetic poles 66 and 68 with respect to the X-axis direction. Though being slightly obstructed by the probe coil 8, the field of view of the subject along the Y-axis direction is almost open. Furthermore, it is completely open in the Z-axis direction. For this reason, the subject placed within the space 78 can secure a large field of view and thus will have no feeling of psychological oppression.

For the same reason, the subject can be placed within the space 78 not only in a lying state as shown in Fig. 7 but also in a standing state, thus increasing the flexibility of imaging body portions. Therefore, it is possible to perform MR imaging of the waist or the like of the subject as he or she stands with stress added to his or her spinal column. This will provide a clinical advantage. When lying on the top board of the couch not shown, the subject stretches out with face up or down. In the case of a standing position, on the other hand, the subject 208 assumes a posture of raising the upper portion of the body on the top board or of standing up with the couch not shown moved.

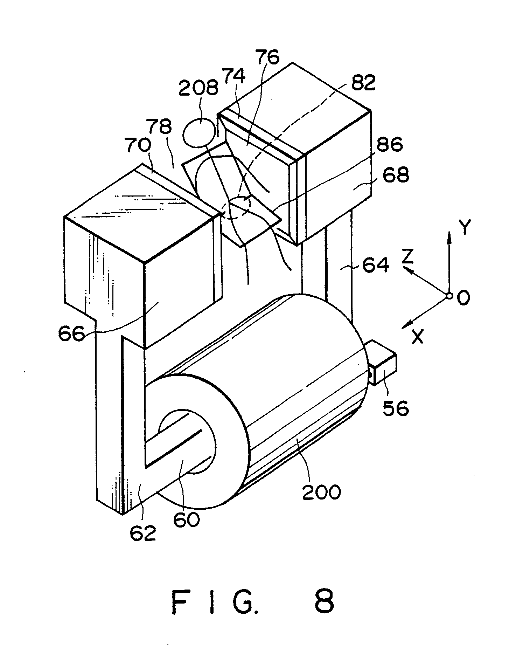

Fig. 8 illustrates apparatus which permits MR imaging of the subject 208 either in a reclining position or in a standing position using a reclining chair. As shown in Fig. 8, a reclining chair 86 which is preferably made of nonmagnetic materials is disposed in the space 78. By adjusting a reclining mechanism of the chair, any of a reclining position, a leaning position and a standing position can be taken freely. A surface coil 82 may be fixed to the chair 86.

With the apparatuses of Figs. 7 and 8, the superconducting magnet 40 is disposed in the lower portion along the vertical direction (Y-axis direction) and the space 78 utilized for imaging is disposed in the upper portion along the vertical direction (Y-axis direction). This configuration may be laid out specifically as follows. That is, the magnetic poles 66, 68 and the space 78 are disposed within an examination room not shown and the superconducting magnet 40 is disposed under the floor of the examination room not shown. This layout will enable the apparatus to be installed in a room with a small floor area. In addition, since the superconducting material 40, which is a large heavy electrical apparatus, is installed out of sight of the subject, oppression that the subject will feel will be reduced.

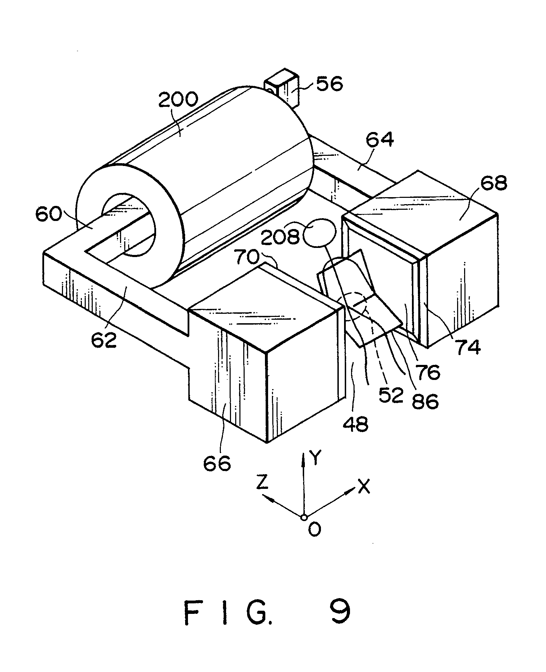

Fig. 9 is a perspective view illustrating a layout which differs from that of Fig. 8 or Fig. 7. In the apparatus of Fig. 9, superconducting magnet 40 is disposed in the back along the horizontal direction (Z-axis direction) and space 78 available for imaging is disposed in the front along the horizontal direction (Z-axis direction). This will be laid out specifically as follows. That is, magnetic poles 66, 68 and space 78 are disposed in an examination room and superconducting magnet 40 is disposed in a room next to the examination room. This layout will permit the apparatus to be installed in an examination room with a small floor area. Likewise, the installation of superconducting magnet 40 out of sight of the subject will reduce oppression of the subject.

In the above embodiments is used the superconducting magnet 40 of a triple vessel structure with a refrigerator. Alternatively, a superconducting magnet of a type in which a superconducting coil and liquid helium are directly housed in a vacuum vessel without using a refrigerator may be used. Various types of superconducting magnets may be used. It goes without saying that a normal conducting magnet may be used. Although a magnet adapted for high magnetic field is used in the illustrated arrangement, a small electromagnet adapted for low static magnetic field may be used. The type and disposition of the gradient field coils and probe coil are not limitative. Of course, the same is true of the couch and the chair.

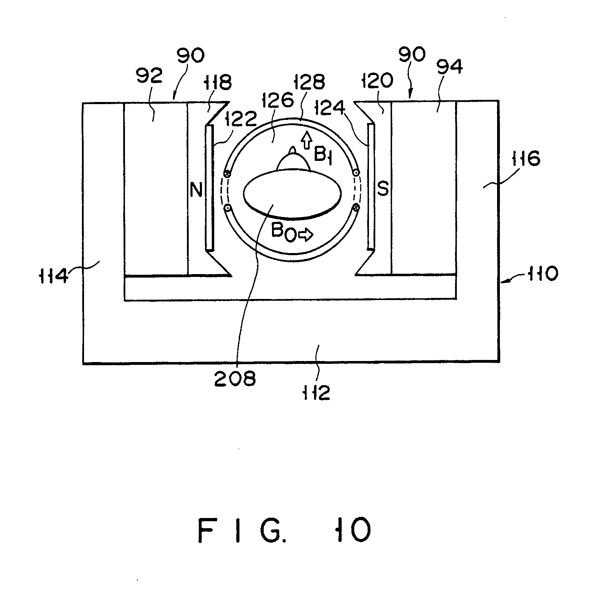

A third embodiment of the magnetic resonance imaging apparatus of the present invention will be described with reference to Figs. 10 to 12.

Fig. 10 is a sectional view of the apparatus of the third embodiment. In this embodiment, two superconducting magnets 92 and 94 are used as electromagnet type static magnetic field forming means 90.

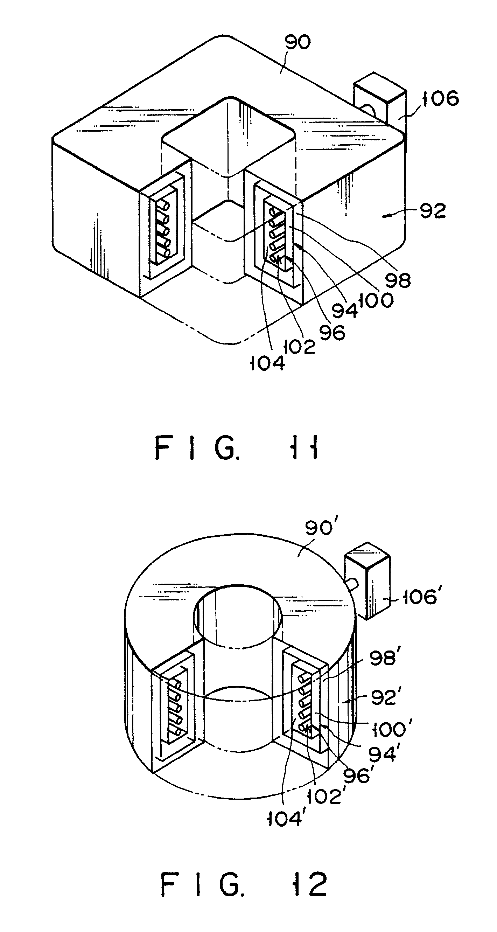

As illustrated partly in section in Fig. 11, the superconducting magnet 90 is of a triple vessel structure having a closed double-cylindrical vacuum vessel 92 with a relatively short axial length and closed axial ends, a shield vessel 94 disposed within the shield vessel 94. A heat insulating material 98 is housed between the vacuum vessel 92 and the shield vessel 94. Another type of heat insulating material 100 is also housed between the heat shielding vessel 94 and the helium vessel 96. In the helium vessel 96 are housed a superconducting coil 102 in which a superconductor is wound in solenoid form as well as liquid helium 104. The heat shielding vessel 94 is cooled by a built-on refrigerator 106. In Fig. 12 is illustrated another arrangement which, unlike the arrangement in Fig. 11, is of a rectangular solid type.

The two superconducting magnets 92 and 94 are incorporated into an iron core 120 which forms a substantially U-shaped magnetic circuit. That is to say, the iron core 120 consists of stacked laminations of high magnetic iron and comprises a yoke 122, a first leg 124 magnetically coupled with one end of the yoke substantially at right angle and a second leg 126 magnetically coupled with the other end of the yoke 122 substantially at right angle. The first leg 124 is provided with the superconducting magnet 92, while the second leg 126 is provided with the superconducting magnet 94. The superconducting magnet 92 and 94 are fixed to the legs 124 and 126, respectively, so that their faces, which are perpendicular to the direction in which magnetic lines of force are produced therefrom, may oppose to each other. The two superconducting magnets 92 and 94 may be electrically connected either in series or in parallel. To secure the stability of a magnetic field, the series connection would be preferable.

The end face of the superconducting magnet 92 that is not coupled to the first leg and the end face of the superconducting magnet 94 that is not coupled to the second leg 126 are opposed to each other. At the end surface of the superconducting magnet 92 are disposed a first pole piece 128 for adjusting magnetic lines of force and a gradient field coil 132. Also, a second pole piece 130 for adjusting·magnetic lines of force and a gradient field coil 134 are disposed at the end face of the superconducting magnet 94. The opposed faces of the superconducting magnets 92 and 94 form a magnetic gap 136 therebetween. By way of example, the end face of the superconducting magnet 92 serves as the N pole, while the end face of the superconducting magnet 94 serves as the S pole.

As can be seen, the yoke 122, the first iron core 124, the second iron core 126, the superconducting magnets 92 and 94 and the magnetic gap 136 form the iron core 120 forming the substantially U-shaped magnetic circuit. Within the space 136 are disposed subject 208 with face upward and saddle-shaped probe coil 138. Although, in Fig. 10, the saddle-shaped probe coil 140 is used, a surface coil or a solenoid coil may be used instead. Here, the Y-axis direction is the vertical direction, the X-axis direction is the horizontal direction along the right and left of the paper and the Z-axis direction is the horizontal direction along the top and bottom of the paper. Thus, the static magnetic field is generated in the X direction, the direction of the line of vision of the subject is oriented in the Y direction, and the body axis of the subject is oriented in the Z direction.

In this case the magnetic gap 136 serves as the static magnetic field generation space where the subject can be placed for imaging. In this case, the field of view of the subject is restricted by the end faces of the superconducting magnets 92 and 94 with respect to the X-axis direction. Though being slightly obstructed by the probe coil 138, the field of view of the subject along the Y-axis direction is almost open. Furthermore, it is completely open in the Z-axis direction. For this reason, the subject placed within the space 138 can secure a large field of view and thus will have no feeling of psychological oppression.

For the same reason, the subject can be placed within the space 136 not only in a lying state as shown in Fig. 10 but also in a standing state, thus increasing the flexibility of body portions for imaging. Therefore, it is possible to perform MR imaging of the waist or the like of the subject as he or she stands with stress added to his or her spinal column. This will provide a clinical advantage. When lying on the top board of the couch not shown, the subject stretches out with face up or down. In the case of a standing position, on the other hand, the subject 208 assumes a posture of raising the upper portion of the body on the top board or of standing up with the couch not shown moved.

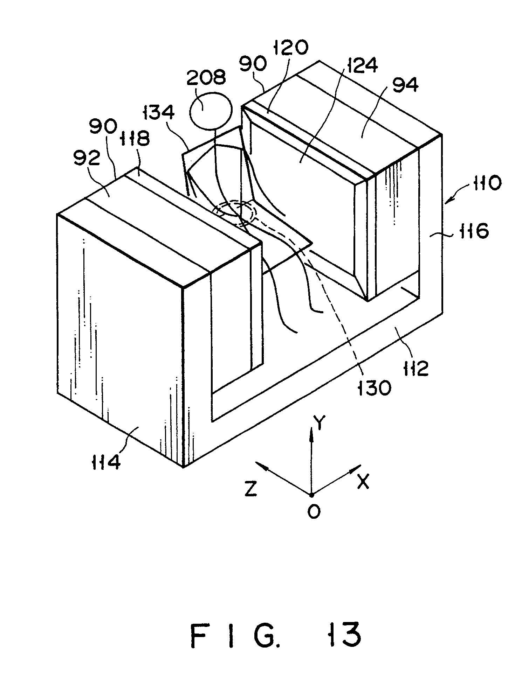

Fig. 13 is a perspective view of apparatus which permits MR imaging of the subject 208 either in a reclining position or in a standing position using a reclining chair. As shown in Fig. 13, a reclining chair 144 which is preferably made of nonmagnetic materials is disposed in the pace 136. By adjusting a reclining mechanism of the chair, any of a reclining position, a leaning position and a standing position can be set freely. A surface coil 140 may be fixed to the chair 144.

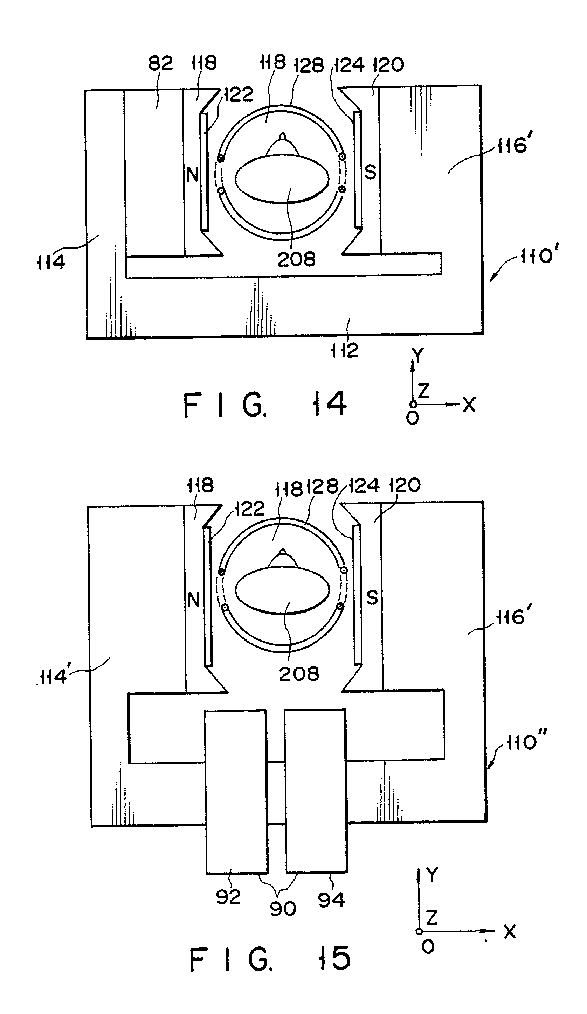

Fig. 14 illustrates an arrangement in which the superconducting magnet 94 is removed from the arrangement of Fig. 10, which is adapted for low-magnetic-field apparatus. In this case, an iron core 120' is used which has a leg 126' adapted to supplement the superconducting magnet 94.

Fig. 15 illustrates an arrangement in which the two superconducting magnets 92 and 94 in the arrangement of Fig. 10 are removed from the legs 124 and 126 and fit on to the yoke 122 as shown and an iron core 120" is used which has legs 124' and 126' adapted to supplement the superconducting magnets 92 and 94.

In the above embodiments is used the superconducting magnet 90 of a triple vessel structure with a refrigerator. Alternatively, a superconducting magnet of a type in which a superconducting coil and liquid helium are directly housed in a vacuum vessel without using a refrigerator may be used. Various types of superconducting magnets may be used.

**Claims**

1. In a magnetic resonance imaging apparatus which induces magnetic resonance within a specific body portion of a subject (108) under examination by placing the subject (108) in a static magnetic field generated by a static magnetic field generating means and applying gradient magnetic fields and a radio-frequency excitation magnetic field and acquires magnetic resonance signals resulting from the magnetic resonance to obtain diagnostic information;
the improvement characterized in that said static magnetic field generating means comprises;
a pair of main magnets (12, 14) disposed to oppose to each other for generating a static magnetic field therebetween and a coupling device 16 (16a, 16b, 16c) coupling said main magnets (12, 14) with each other and having an access aperture (16b) into which a top board (106) on which the subject (108) is to be placed is entered and an opening provided above said access aperture (16c).

2. A magnetic resonance imaging apparatus according to claim 1, characterized in that said pair of main magnets (12, 14) are a pair of electromagnets.

3. A magnetic resonance imaging apparatus according to claim 1, characterized in that said pair of main magnets are a pair of superconducting magnets.

4. A magnetic resonance imaging apparatus according to claim 1, characterized in that said static magnetic field generating means includes magnetic materials (12b to 12d, 14b to 14d) for confining magnetic lines of force from said main magnets (12, 14) within the inside of said generating means, said magnetic materials being provided at end portions of said generating means.

5. A magnetic resonance imaging apparatus according to claim 1 or 4, characterized in that said coupling device (16) is constructed from a plurality of magnetic members (16a) made of a magnetic material.

6. A magnetic resonance imaging apparatus according to claim 5, characterized in that said magnetic members (16c) comprise three to six members.

7. A magnetic resonance imaging apparatus according to claim 1 or 4, characterized in that each of said main magnets (12, 14) contains a magnetic material (16a) for strengthening magnetic lines of force.

8. A magnetic resonance imaging apparatus according to claim 1, characterized in that gradient magnetic field coils (18) and transmitting and receiving means (30a, 30b, 30c) are incorporated into said coupling device (16).

9. A magnetic resonance imaging apparatus according to claim 8, characterized in that a receiving element in said transmitting and receiving means is a solenoid coil (30a).

10. A magnetic resonance imaging apparatus according to claim 1, characterized in that said coupling device (16) forms a space (16b) therein to accommodate the subject (108).

11. A magnetic resonance imaging apparatus according to claim 2, characterized in that said pair of electromagnets are electrically connected in series.

12. A magnetic resonance imaging apparatus according to claim 2, characterized in that said pair of electromagnets (12, 14) are electrically connected in parallel.

13. A magnetic resonance imaging apparatus according to claim 3, characterized in that said pair of superconducting magnets (12, 14) include a coupling tube (32) which reciprocates a cooling medium for causing a superconducting state between said superconducting magnets (12, 14).

14. A magnetic resonance imaging apparatus according to claim 13, characterized in that a conductor for connecting said pair of superconducting magnets (12, 14) electrically is disposed within said coupling tube (32).

15. In a magnetic resonance imaging apparatus which induces magnetic resonance within a specific body portion of a subject under examination by placing the subject in a static magnetic field generated by a static magnetic field generating means and applying gradient magnetic fields and a radio-frequency excitation magnetic field and acquires magnetic resonance signals resulting from the magnetic resonance to obtain diagnostic information;
the improvement characterized in that said static magnetic field generating means (40) comprises;

a static magnetic field generating coil (52, 200), a yoke (60), a first magnetic pole (66) magnetically coupled with an end of said yoke and a second magnetic pole (68) magneticaly coupled with the other end of said yoke (60) and opposed to said first magnetic pole (66).

16. A magnetic resonance imaging apparatus according to claim 15, characterized in that said static magnetic field generating coil (52, 200), said yoke (60), said first magnetic pole (66) and said second magnetic pole (68) are disposed horizontally.

17. A magnetic resonance imaging apparatus according to claim 15, characterized in that said static magnetic field generating coil (52, 200), said yoke (60), said first magnetic pole (66) and said second magnetic pole (68) are disposed vertically such that said coil (52, 200) and said yoke (60) are positioned below and said first and second magnetic poles (66, 68) are positioned above.

18. A magnetic resonance imaging apparatus according to claim 15, characterized in that said static magnetic field generating coil (52, 200) is formed of a superconductor.

19. A magnetic resonance imaging apparatus according to claim 15, characterized in that said static magnetic field generating coil (52, 200) is formed of a normal conductor.

20. A magnetic resonance imaging apparatus according to claim 15, characterized in that gradient magnetic field coils (72), transmitting and receiving means (80) and the subject (208) are disposed between said first and second magnetic poles (66, 68).

21. A magnetic resonance imaging apparatus according to claim 15, 16 or 17, characterized in that a reclining chair for the subject (208) is disposed between said first and second magnetic poles (66, 68).

22. In a magnetic resonance imaging apparatus which induces magnetic resonance within a specific body portion of a subject (208) under examination by placing the subject (208) in a static magnetic field generated by a static magnetic field generating means and applying gradient magnetic fields and a radio-frequency excitation magnetic field and acquires magnetic resonance signals resulting from the magnetic resonance to obtain diagnostic information;
the improvement characterized in that said static magnetic field generating means comprises;
an iron core (120) having a magnetic gap (136) in which the subject (208) is placed ad forming a substantially U-shaped magnetic circuit and a coil (92, 94) disposed to pass magnetic flux through said magnetic circuit of said iron core.

23. A magnetic resonance imaging apparatus according to claim 22, characterized in that said coil (92, 94) is formed of a superconductor.

24. A magnetic resonance imaging apparatus according to claim 22, characterized in that said coil (92, 94) is formed of a normal conductor.

25. A magnetic resonance imaging apparatus according to claim 22, characterized in that gradient magnetic field coils (122, 124), transmitting and receiving means (128) and the subject (208) are disposed in said magnetic gap (136).

26. A magnetic resonance imaging apparatus according to claim 22 or 25, characterized in that a reclining chair (134) for the subject (208) is disposed in said magnetic gap (136).

F I G. 1

F I G.    2

F I G. 3

F I G. 4

F I G. 5A    F I G. 5B    F I G. 5C

F I G.    6

F I G. 7

FIG. 8

FIG. 9

F I G. 10

17

F I G. 11

F I G. 12

F I G. 13

82 118 118 128 124 120
122
N S
116'
114
208
110'
112
Y
Z
O X

F I G. 14

118 118 128 124 120
122
N S
116'
114'
208
110"
92 94
90

Y
Z
O X

F I G. 15

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 314 262 (THE REGENTS OF THE UNIVERSITY OF CALIFORNIA)<br>* column 4, line 35 - column 6, line 55; figures 4-8 *<br>— — — | 1,2,4,5,10 | G 01 R 33/38<br>G 01 R 33/28 |
| A | | 7-9 | |
| X | GB-A-2 215 522 (PICKER INTERNATIONAL LTD.)<br>* page 2, line 32 - page 3, line 32; page 4, line 29 - page 5, line 1; figures 1,4 *<br>— — — | 22,24 | |
| A | | 15,16,19, 20,22,24 | |
| A | WO-A-8 804 057 (FONAR CORP.)<br>* abstract; figure 2 *<br>— — — — — | 3,13,18, 23 | |
| | | | **TECHNICAL FIELDS SEARCHED (Int. Cl.5)**<br><br>G 01 R 33/00 |

The present search report has been drawn up for all claims

| Place of search | Date of completion of search | Examiner |
|---|---|---|
| Berlin | 24 January 91 | WEIHS J.A. |